(19) **Europäisches Patentamt**

**European Patent Office**

**Office européen des brevets**

(11) Publication number: **0 088 463**
**B1**

(12) **EUROPEAN PATENT SPECIFICATION**

(45) Date of publication of patent specification: **08.10.86**

(21) Application number: **83200273.7**

(22) Date of filing: **23.02.83**

(51) Int. Cl.⁴: **H 01 J 37/34**, C 23 C 14/34, H 01 J 37/20

(54) Magnetron cathode sputtering system.

(30) Priority: **05.03.82 NL 8200902**

(43) Date of publication of application:
**14.09.83 Bulletin 83/37**

(45) Publication of the grant of the patent:
**08.10.86 Bulletin 86/41**

(84) Designated Contracting States:
**AT CH DE FR GB IT LI NL**

(56) References cited:
**FR-A- 846 557**
**US-A-4 204 936**

**IBM TECHNICAL DISCLOSURE BULLETIN, vol. 20, no. 1, June 1977, pages 228-229, Armonk, New York, USA H. BOHLEN et al.: "Workpiece holder"**

**IBM TECHNICAL DISCLOSURE BULLETIN, vol. 13, no. 12, May 1971, page 3651, Armonk, New York, USA P. FIORE et al.: "Wafer holding pedestal"**

(73) Proprietor: **N.V. Philips' Gloeilampenfabrieken**
**Groenewoudseweg 1**
**NL-5621 BA Eindhoven (NL)**

(72) Inventor: **Crombeen, Jacobus Eduardus**
**c/o INT.OCTROOIBUREAU B.V. Prof.Holstlaan 6**
**NL-5656 AA Eindhoven (NL)**
Inventor: **Crooymans, Petrus Wilhelmus Henricus Maria**
**c/o INT.OCTROOIBUREAU B.V. Prof.Holstlaan 6**
**NL-5656 AA Eindhoven (NL)**
Inventor: **Visser, Jan**
**c/o INT.OCTROOIBUREAU B.V. Prof.Holstlaan 6**
**NL-5656 AA Eindhoven (NL)**

(74) Representative: **Koppen, Jan et al**
**INTERNATIONAAL OCTROOIBUREAU B.V. Prof. Holstlaan 6**
**NL-5656 AA Eindhoven (NL)**

Courier Press, Leamington Spa, England.

## Description

The invention relates to a magnetron cathode sputtering system comprising in an envelope an anode and a flat cathode composed of a target, which target is connected against a backing plate, means being provided on the backing plate away form the target to provide a magnetic field for the said target in the envelope.

The target is a plate of the material to be sputtered and is connected against a backing plate, which is a supporting plate for the target.

Such systems are frequently used for providing thin films of a material on substrates. During operation of the magnetron cathode sputtering system the substrate is placed in the envelope, the envelope being filled within a gas. By applying a sufficiently high potential between the anode and the cathode, a gas discharge is formed in which gas ions impinge on the target at high velocity and liberate the material therefrom (mainly atoms). This sputtered material is then captured by the substrate. By providing tunnels of magnetic field lines for the target, which tunnels trap electrons, more ions are formed and hence the sputtering process is intensified. As a result of this the desired layer is formed more rapidly on the substrate. In such systems the target must be very readily cooled so as to prevent the target from melting and to pevent the target from giving off too much heat by radiation.

A magnetron cathode sputtering system of the kind mentioned in the opening paragraph is known from United States Patent Specification 4,204,936, The target described in said Patent Specification is clamped against the backing plate by means of one or more magnets, the magnets cooperating with magnets present behind the backing plate. A disadvantage of such a device is that the clamping force per surface unit is low. Moreover the magnetic field for the target is adversely influenced. Such sputtering systems are used for the manufacture of optical information carriers, in which a substrate consisting of a thin plastic or glass disc in which the information is present in the form of a large number of pits, is covered with a thin metal film. So far the targets were sometimes connected to the backing plate via a soldered joint so as to produce a good mechanical and thermal contact. However, when the target is soldered to the backing plate and the target is worn out by sputtering, it is very difficult to separate the target and backing plate from each other in order that the backing plate can be used again. Moreover it is difficult in the case of large dimensions of the two plates to realize a homogeneous soldered joint throughout the surface. British Patent Specification 1,311,042 disclosed a high-frequency cathode sputtering system in which a target is secured against the backing plate by means of a screwed clamping ring. A material readily conducting thermal energy for example a liquid metal or a metal paste is provided between the target and the backing plate. With such a cooling arrangement it has also proved impossible to produce a very homogeneous thermal contact between the target and the backing plate which is necessary for a magnetron cathode sputtering system. Moreover, seals have to be provided so as to prevent the liquid from being disposed in the envelope.

In "IBM Technical Disclosure Bulletin", Vol. 20, No. 1 (1977), pages 228,229 a workpiece holder is described for processing a plate-shaped workpiece. For processing said workpiece in a vacuum chamber by means of an electron beam, the workpiece, to eliminate unevenness, must be pressed firmly onto a plane support. This is effected before the chamber is evacuated by using vacuum chucks with high forces of attraction. Then by switching on an electric field, an electrostatic chuck becomes active, retaining the workpiece in the attracted position when the chamber is evacuated for processing the workpiece. At the moment the chamber is evacuated the chuck function is finished automatically. It is the object of the invention to provide a magnetron cathode sputtering system in which the thermal contact between the target and the backing plate is very homogeneous and in which the target can very simply be connected against the backing plate and can later be removed again.

A magnetron cathode sputtering system of the kind mentioned in the opening paragraph is characterized according to the invention in that the peripheral portion of the target abuts against the peripheral portion of an aperature in the envelope in a gas-tight manner, the said backing plate having a plurality of channels which open into the contact face of target and backing plate, the backing plate being secured against the target by vacuum suction via the said channels.

Because a comparatively low pressure (0.001 Torr = 0,1333 Pascals) prevails in the envelope during the sputtering process it is necessary for the edge of the target to bear on the edge of the aperture in the envelope. By vacuum suction via the said channels, the backing plate is constantly pressed against the target as a result of the atmospheric pressure. Because the orifices of the channels can be regularly distributed over the contact face of the target and the backing plate, a very homogeneous pressure necessary for a homogeneous heat transfer is obtained. The heat transfer can even be improved by providing the contact face of the target and backing plate with a thin layer of soldering material, which soldering material does not adhere to the said target but does adhere to the backing plate, said soldering material having a melting temperatue which is a few to a few tens of degrees above the operating temperature of the cathode. By passing boiling water through the cooling channels during the connection of the backing plate, the soldering material melts and after cooling adheres to the backing plate. Furthermore, as a result of the homogeneous and constant pressure it fills the space, if any, between the target and the backing plate entirely so that a very good heat transfer is obtained between the target and the backing plate which is from 8 to 10 times larger than the heat transfer when, for example, a heat conductive paste is used. An example of a suitable soldering material is Bi 50 Pb 26.7 Sn 13.3 Cd 10 or Bi 49 Pb 18 Sn 12 In 21 or Bi 34 In 66. These compositions are given in % by weight. It is described in the United States Patent Specification 4,204,936 that a layer of soldering material is provided between the target and the backing plate so as to promote the heat transport. The backing plate is covered with a thin layer of nickel, so that the solder does not adhere to the backing plate. However, said nickel layer constitutes a disturbing short-circuit of the magnetic field. Moreover, in this method fresh soldering material has to be used over and over again, since the soldering material adheres to the target.

The invention will now be described in greater detail, by way of example, with reference to the accompanying drawing, in which

Fig. 1 is a diagrammatic sectional view of a magnetron cathode sputtering system according to the invention and

Fig. 2 is a cross-sectional view of a detail of Fig. 1.

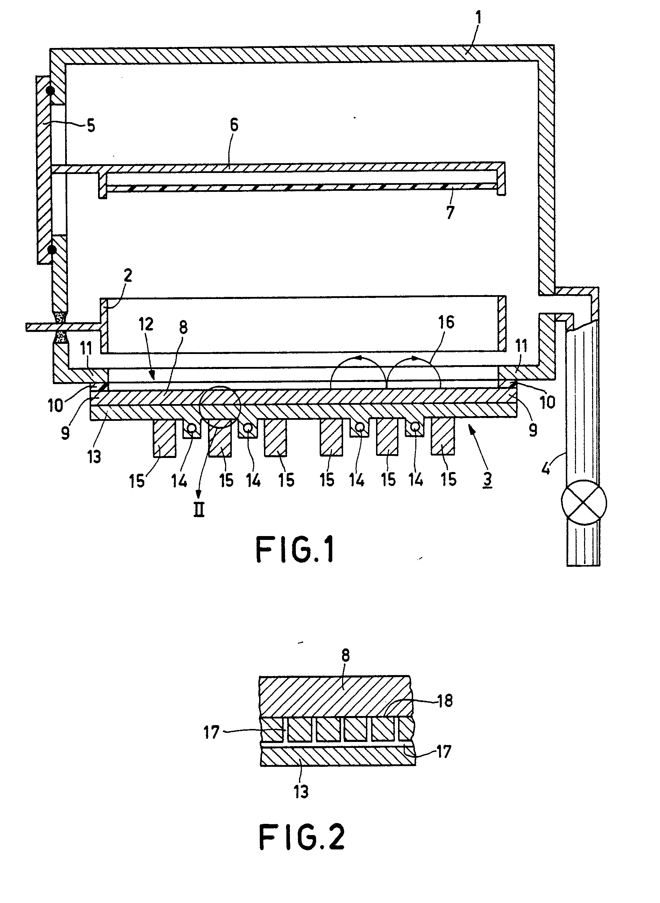

The magnetron cathode sputtering system as shown diagrammatically in Fig. 1 comprises in an envelope 1 an annular anode 2 and a cathode system 3. The envelope 1 can be evacuated *via* the exhaust tube 4 and be filled with a gas (for example with argon). The envelope furthermore comprises a sluice 5 to which a holder 6 is connected for the substrate 7 to be sputtered. The substrate is, for example a plastic disc-shaped record carrier as is used in the video-long-play (V.L.P.) system of N.V. Philips' Gloeilampenfabrieken, which is described *inter alia* in Philips Techn. Rev. 33, 178—180, 1973, No. 7. The cathode system 3 consists, for example, of a 1 cm thick aluminium target 8 which forms the material to be sputtered.

The edge 9 of the target 8 is connected against the edge 11 of aperature 12 in the envelope 1 by means of a sealing ring 10 of an insulating material. A backing plate 13 which is connected against the target 8 comprises a cooling duct 14 through which cooling liquid flows so as to dissipate the thermal energy originating from the target 8. A number of magnets 15 are connected against the backing plate 13 and generate tunnels of magnetic field lines 16 in front of the surface of the target 8. In these tunnels the electrons originating from the cathode are trapped and ionise the gas in the envelope close to the cathode. Because now more ions are formed which impinge on the target 8, the sputtering process is intensified. As a result of this the target 8 becomes hotter than without the use of the magnets.

Fig. 2 is a sectional view of the detail of Fig. 1 encircled by the ring II. The backing plate 13 comprises a large number of channels 17 which open into the contact face 18 of target 8 and backing plate 13. By evacuating the channels 17, the backing plate 13 is contacted homogeneously with plate 8 by suction so that a very good heat transfer is obtained over the whole contact face. This contact can even be improved by providing, as already described, a layer of soldering material between the target 8 and the backing plate 13, which solder adheres only to the backing plate 13.

In Fig. 1 two annular tunnels of field lines 16 are present in front of the target 8 in the envelope. Of course more annular tunnels or only one annular tunnel may be used. The tunnel may also have a different shape. The field lines may also extend parallel to the surface of the target 8 and form a shield of magnetic field lines. The target and the backing plate are preferably circular, but they may also have a square, rectangular or any other desired shape.

**Claims**

1. A magnetron cathode sputtering system comprising in an envelope (1) an anode (2) and a flat cathode (3) comprising a target (8), which target (8) is connected against a backing plate (13), means (15) being provided on the backing plate away from the target to provide a magnetic field (16) for the said target (8) in the envelope, characterized in that the peripheral portion (9) of the target (8) abuts against the peripheral portion (11) of an aperture (12) in the envelope (1) in a gas-tight manner, said backing plate (13) comprising a plurality of channels (17) which open into the contact face (18) of the target (8) and the backing plate (13), the backing plate (13) being connected against the target (8) by vacuum suction *via* the said channels (17).

2. A magnetron cathode sputtering system as claimed in Claim 1, characterized in that the contact face (18) of the target (8) and the backing plate (13) comprises a thin layer of soldering material, which soldering material does not adhere to the said target (8) but does adhere to the said backing plate (13), said soldering material having a melting temperature which is above the operating temperature of the cathode (3).

3. A magnetron cathode sputtering system as claimed in Claim 2, characterized in that the melting temperature of the soldering material is between 70 and 100°C.

4. Use of the magnetron sputtering system as claimed in Claim 1, 2 or 3, for coating disc-shaped record carriers (7) with a light reflecting film.

**Patentansprüche**

1. Magnetron-Kathodenzerstäubungssystem mit einer Anode (2) und einer flachen Kathode (3) in einer Umhüllung (1), wobei die flache Kathode aus einem aud einer Stützplatte (13) befestigten Target besteht, wobei aud der Stützplatte abseits des Targets Mittel (15) zum Erzeugen eines Magnetfeldes (16) für das genannte Target (8) in der Umhüllung vorgesehen sind, dadurch gekennzeichnet, dass sich das umgebende Gebiet (9) des Targets (8) auf dem umgebenden Gebiet (11) einer Öffnung (12) in der Umhüllung (1) auf

gasdichte Weise abstützt, wobei die Stützplatte (13) eine Vielzahl von Kanälen (17) enthält, die in die Kontaktfläche (18) des Targets (8) und der Stützplatte (13) münden, wobei die Stützplatte (13) am Target (8) durch Vakuumsaugen über die genannten Kanäle (17) befestigt ist.

2. Magnetron-Kathodenzerstäubungssystem nach Anspruch 1, dadurch gekennzeichnet, dass Kontaktfläche (18) des Targets (8) und der Stützplatte (13) eine dünne Lötmittelschicht enthält und diese Lötmittel nicht am Target (8) haftet, sondern nur an der genannten Stützplatte (13), und diesen Lötmittel eine Schmelztemperatur besitzt, die über Betriebstemperatur der Kathode (3) liegt.

3.. Magnetron-Kathodenzerstäubungssystem nach Anspruch 2, dadurch gekennzeichnet, dass die Schmelztemperatur des Lötmittels zwischen 70 und 100°C liegt.

4. Verwendung des Magnetron-Kathodenzerstäubungssystem nach Anspruch 1, 2 oder 3, zur Beschichtung scheibenförmiger Aufzeichnungsträger (7) mit einem Licht reflektierenden Film.

**Revendications**

1. Système de pulvérisation cathodique magnétron comportant, une enveloppe (1), dans laquelle sont disposées une anode (2) et une cathode plane (3) composée d'une cible (8), qui est fixée sur une plaque porteuse (13), alors que des moyens sont prévus sur la plaque porteuse du côté opposé à la cible afin de fournir un champ magnétique (16) pour ladite cible dans l'enveloppe, caractérisé en ce que la partie périphérique (9) de la cible (8) est en contact avec la partie périphérique (11) d'une ouverture (12) dans l'enveloppe 1 d'une façon étanche au gaz, ladite plaque porteuse (13) présentant une pluralité de canaux (17) qui débouchent dans la face de contact (18) de la cible (8) et de la plaque porteuse (13), la plaque porteuse (13) étant fixée par aspiration à vide sur la cible (8) par l'intermédiaire desdits canaux (17).

2. Système de pulvérisation cathodique magnétron selon la revendication 1, caractérisé en ce que la face de contact (18) de la cible (8) et la plaque porteuse (13) comportent une couche mince en matériau de soudure, qui n'adhère pas à ladite cible (8) mais, qui le fait à ladite plaque (13), ledit matériau de soudure présentant un point de fusion qui supérieur à la température de fonctionnement de la cathode (3).

3. Système de pulvérisation cathodique magnétron selon la revendication 2, caractérisé en ce que la température de fusion du matériau de soudure est comprise enter 70 et 100°C.

4. Utilisation du système de pulvérisation cathodique magnétron selon la revendication 1, 2 ou 3, pour le recouvrement de porteurs d'enregistrement en forme de disque (7) présentant un film réfléchissant la lumière.

0 088 463

FIG.1

FIG.2

1